# EUROPEAN PATENT APPLICATION

(11) **EP 3 163 414 A1**
(43) Date of publication of application: **03.05.2017**
(21) Application number: 15810887.8
(22) Date of filing: 25.06.2015
(51) Int. Cl.: G06F 3/041, G06F 3/044, G06F 3/033

(54) **COORDINATE INPUT DEVICE HAVING ENHANCED TOUCH SENSING PERFORMANCE**

(30) Priority: 25.06.2014 KR 20140078449; 25.06.2014 KR 20140078492; 25.06.2014 KR 20140078510
(71) Applicant: NP Holdings Co. Ltd., Suwon-si, Gyeonggi-do 443-390 (KR)
(72) Inventor: CHOI, Do-hyun, Yongin-si Gyeonggi-do 446-995 (KR)
(74) Representative: Ligi, Stefano
(86) International application number: PCT/KR2015/006484
(87) International publication number: WO 2015/199458

(57) **Abstract**

The coordinate input device of the present invention includes a sensing panel that has a plurality of sensing strip antennas, and a sensing control circuit that controls the sensing panel to sense a touch input and calculate corresponding touch input coordinates to provide the coordinates to a host. The coordinate input device of the present invention may also include a sensing control circuit that calculates touch input coordinates based on a variation in electrical characteristic values related to the impedance matching of a scan signal with respect to the touch input of an electrostatic object, and senses all of the touch inputs of the electrostatic object and a stylus pen by using the same and one sensing panel without having a separate digitizer panel for sensing the respective touch inputs of the stylus pen, by using the change function of a touch sensing mode.

## Description

### [Field of the invention]

This invention is about a coordinate input device and, in particular, about coordinate input device which can sense both touch input of capacitive object and touch input of stylus pen which is equipped with resonance circuit.

### [Background]

Coordinate input device has been broadly used in computer- based user interface such as touch screen and digitizer. In case of touch screen, various sensing panel are used according to the ways of detecting touch. As representative ways of touch sensing, there are resistant film way, capacitive way, infrared way, ultrasonic waves way and camera way. As for capacitive way, it is broadly used for small and mid- sized portable devices such as smart phone and tablet PC. Meanwhile, as for digitizer, it is broadly used in graphic application areas because sensitive touch input is available.

Recently, digitizer starts to be loaded into those devices along with touch screen of capacitive way in that people want to realize respective merits of them in one device. However, sensing panel with capacitive way and digitizer panel are independently loaded into devices, which become a factor of price rise. In addition, as for touch screen with capacitive way, display panel is placed on its front and a number of restrictive problems in manufacturing devices are caused. If capacitive- typed touch screen can be placed in the rear of display, a lot of advantages can be taken in manufacturing and technical aspects but its performance in tough sense is behind.

### [Details of the Invention]

### [Tasks Intended to be Solved]

The purpose of this invention is to provide coordinate input device having more improved touch sense performance or provide coordinate input device which can sense both touch of capacitive object and touch input of stylus pen embedding resonant circuit by using one sensing panel.

### [Means of Task Solution]

One feature of this invention to achieve technical task as mentioned above is regarding coordinate input device having improved touch sense performance. The coordinate input device of this invention includes: the first sensing strip antenna group for detecting the first coordinate in touch input coordinate, multiple sensing strip antenna including the 2nd sensing strip antenna for detecting the second coordinate in touch input coordinate and sensing control circuit which calculates touch input coordinate based on variation of electric property related to impedance matching of scan signal as mentioned above, which is generated in responding to touch input coordinate of black object above.

As an embodiment, sensing control circuit as mentioned above consists of : the first scan switching part for selectively driving the first sensing strip antenna group; the second scan switching part for selectively driving the second sensing strip antenna group; scan signal source which generates scan signals of the first and second frequencies; the first impedance interface which is formed between scan signal source and the first scan switching part ; the 2nd impedance interface which is formed between scan signal source and the second scan switching part ; capacitive touch detecting element which conducts electric signal processing for detecting variations of electric property related to impedance matching of scan signals of the first and second frequencies which respectively are approved in the first and second sensing strip antenna group at the same time; and the controller which calculates touch input coordinate of capacitive object by receiving input signals processed through detecting part of capacitive touch detecting variations of electric property related to impedance matching regarding the scan signals of the first and second frequencies as .

As an embodiment, the detecting part of capacitive touch includes voltage sensor and current sensor which are used to detect electric property of scan signal of capacitive touch

As another embodiment, multiple sensing strip antenna as has the first touch sense mode operating to detect touch input of capacitive object and the second touch sense mode operating to detect touch input of stylus pen embedding resonant circuit. Sensing control circuit includes: touch mode switching part making switching motion so that scan signal of the first frequency in the first touch sense mode are output to the first scan switching part, and, at the same time, the scan sign of the 2nd frequency will be output in the 2nd scan switching part as and, in the 2nd touch sense mode,, the scan signal of the 1st frequency will be output in the 1st and 2nd scan switching parts in order; and pen touch detection part where electric signal processing is performed for detecting touch input coordinate of stylus pen by detecting electric signal from multiple sensing strip antenna in the 2nd touch sense mode. Controller calculates touch input coordinate of stylus pen by receiving signals which have been processed through pen touch detection part in the 2nd touch sense mode and detecting whether radio frequency signals, which is transmitted from resonating of scan signals of the 1st frequency, are received

As an another embodiment, touch mode switching part runs switching in a way that the 1st frequency signal in the 2nd touch sense mode does not pass through the 1st impedance interface and be output in order to the 2nd scan switching part.

In the embodiment above, power transmission antenna is included for transmitting power to stylus pen embedding resonant circuit, the multiple sensing strip antenna have the 1st touch sense mode running to detecting touch input of capacitive object and the 2nd touch sense mode running to detecting touch input of stylus pen. The sensing control circuit runs switching motion in a way that the scan signal of 1st touch sense mode is output in the 1st scan switching part and, at the same time, the scan signal of the 2nd frequency can be output in the 2nd scan switching part. In the 2nd touch sense mode includes touch mode switching part which runs switching motion to make the scan signal of the 1st frequency output in the power transmission antenna; and pen touch detection part where electric signal processing is performed to detect touch input coordinate of stylus pen by detecting electric signal from multiple sensing strip antenna in the 2nd touch sense mode. The controller calculates touch input coordinate of stylus pen by detecting reception of radio frequency signal which is transmitted by resonated scan signal of the 1st frequency in resonant circuit of stylus pen by receiving input of processed signal through pen touch detection part.

As an embodiment, sensing control circuit includes: the 1st scan switching part for selective running the 1st sensing strip antenna group; the 2nd scan switching part for selective running of the 2nd sensing strip antenna group; the 1st impedance interface to be formed between scan signal source and the 1st scan switching part; capacitive touch detection part performing electric signal processing to detect variations of electric property related to impedance matching of scan signal of the 1st frequency which is loaded in the 1st sensing strip antenna group ; the 2nd impedance interface connected between the 2nd scan switching part and capacitive touch detection part; and controller which calculates touch input coordinate of capacitive object by detecting variation of electric property related to impedance matching on scan signal of the 1st frequency according to touch of capacitive object after receiving signals which have been processed through capacitive touch detection part.

As an embodiment, capacitive touch detection part includes voltage sensor and current sensor for detecting electric property of capacitive touch scan signals.

As an embodiment, multiple sensing strip antenna have the 1st touch sense mode running for detecting touch input of capacitive object and the 2nd touch sense mode running for detecting touch input of stylus pen embedding resonant circuit. Sensing control circuit includes: touch mode switching part running switching motion to make scan signal of the first frequency input in the 2nd impedance interface and, in the 2nd touch sense mode, the scan signal of the 1st frequency will be output in the 1st and 2nd scan switching parts in order; and pen touch detection part where electric signal processing is performed for detecting touch input coordinate of stylus pen by detecting electric signal from multiple sensing strip antenna in the 2nd touch sense mode. Controller calculates touch input coordinate of stylus pen by receiving signals which have been processed through pen touch detection part in the 2nd touch sense mode and detecting whether radio frequency signals, which is transmitted from resonating of scan signals of the 1st frequency, are received

As an another embodiment, touch mode switching part runs switching in a way that the 1st frequency signal in the 2nd touch sense mode does not pass through the 1st impedance interface and be output to the 1st scan switching part and 2nd scan switching part in order.

As another embodiment, power transmission antenna is included for transmit power to stylus pen embedding resonant circuit and multiple sensing strip antenna as has the 1st touch sense mode operating to detect touch input of capacitive object and the 2nd touch sense mode operating to detect touch input of stylus pen. Sensing control circuit includes: touch mode switching part making switching motion so that scan signal of the 1st frequency in the 1st touch sense mode is output to the 1st scan switching part , and, the scan sign of the 1st frequency output through the 2nd scan switching part will be input to the 2nd impedance interface and, in the 2nd touch sense mode, the scan signal of the 1st frequency will be output to the power transmission antenna; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit

As an embodiment, coordinate input device includes: multiple sensing strip antenna including the 1st sensing strip antenna group for detecting the 1st coordinate in touch input coordinate and the 2nd sensing strip antenna group for detecting the 2nd coordinate in touch input coordinate; sensing panel including conductive wire consisting multiple sensing strip antenna and substrate where such conductive wire is attached with the glue; and sensing control circuit which supplies scan signals for detecting touch input coordinate of capacitive object to the multiple sensing strip antenna and calculate touch input coordinate based on the electric property related to impedance interface of scan signal which is generated to respond to touch input coordinate of capacitive object.

As an embodiment, the 1st and 2nd sensing strip antenna group consists of different connected conductive wire and includes multiple taps connected to such conductive wire.

As an embodiment, sensing control circuit includes: the 1st scan switching part for selective running the 1st sensing strip antenna group; the 2nd scan switching part for selective running of the 2nd sensing strip antenna group; scan signal source generating scan signals of the 1st and the 2nd frequency; the 1st impedance interface to be formed between scan signal source and the 1st scan switching part; the 2nd impedance interface to be formed between scan signal source and the 2nd scan switching part; capacitive touch detection part performing electric signal processing to detect variations of electric property related to impedance matching of scan signal of the 1st and the 2nd frequency which is loaded in the 1st and the 2nd sensing strip antenna groups at the same time; and the controller which calculates touch input coordinate of capacitive object by detecting variation of electric property related to impedance matching on scan signal of the 1st and the 2nd frequencies according to touch of capacitive object after receiving signals which have been processed through capacitive touch detection part.

As an embodiment, capacitive touch detection part includes voltage sensor and current sensor for detecting electric property of capacitive touch scan signals.

As another embodiment, the multiple sensing strip antenna as has the 1st touch sense mode operating to detect touch input of capacitive object and the 2nd touch sense mode operating to detect touch input of stylus pen. Sensing control circuit includes: touch mode switching part making switching motion so that scan signal of the 1st frequency in the 1st touch sense mode be output to the 1st scan switching part , and, in the 2nd touch sense mode, the scan sign of the 1st frequency be output to the 1st and 2nd scan switching parts in order; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit

As an another embodiment, touch mode switching part runs switching motion in a way that the 1st frequency signal in the 2nd touch sense mode does not pass through the 1st impedance interface and be output to the 1st scan switching part and 2nd scan switching part in order

As an embodiment, power transmission antenna is included for transmit power to stylus pen embedding resonant circuit and multiple sensing strip antenna as has the 1st touch sense mode operating to detect touch input of capacitive object and the 2nd touch sense mode operating to detect touch input of stylus pen. Sensing control circuit includes: touch mode switching part making switching motion so that scan signal of the 1st frequency in the 1st touch sense mode is output to the 1st scan switching part , and, at the same time, the scan sign of the 2nd frequency will be output to the 2nd scan switching part and, in the 2nd touch sense mode, the scan signal of the 1st frequency will be output to the power transmission antenna; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit

As an embodiment, sensing control circuit includes: the 1st scan switching part for selective running the 1st sensing strip antenna group; the 2nd scan switching part for selective running of the 2nd sensing strip antenna group; scan signal source generating scan signals of the 1st frequency; the 1st impedance interface to be formed between scan signal source and the 1st scan switching part; capacitive touch detection part performing electric signal processing to detect variations of electric property related to impedance matching of scan signal of the 1st frequency which is loaded in the 1st sensing strip antenna groups at the same time; the 2nd impedance interface connected between the 2nd scan switching part and capacitive touch detection part ; and the controller which calculates touch input coordinate of capacitive object by detecting variation of electric property related to impedance matching on scan signal of the 1st frequencies according to touch of capacitive object after receiving signals which have been processed through capacitive touch detection part.

As an embodiment, capacitive touch detection part includes voltage sensor and current sensor for detecting electric property of capacitive touch scan signals.

As another embodiment, the multiple sensing strip antenna as has the 1st touch sense mode operating to detect touch input of capacitive object and the 2nd touch sense mode operating to detect touch input of stylus pen. Sensing control circuit includes: touch mode switching part making switching motion so that scan signal of the 1st frequency in the 1st touch sense mode will be output to the 1st scan switching part , and, the scan signal of the 1st frequency to be output through the 2nd scan switching part will be input to the 2nd impedance interface , and, in the 2nd touch sense mode, the scan sign of the 1st frequency will be output to the 1st and 2nd scan switching parts in order; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit

As an another embodiment, touch mode switching part runs switching motion in a way that the 1st frequency signal in the 2nd touch sense mode does not pass through the 1st impedance interface and be output to the 1st scan switching part and 2nd scan switching part in order

As an embodiment, power transmission antenna is included for transmit power to stylus pen embedding resonant circuit and multiple sensing strip antenna as has the 1st touch sense mode operating to detect touch input of capacitive object and the 2nd touch sense mode operating to detect touch input of stylus pen. Sensing control circuit includes: touch mode switching part making switching motion so that scan signal of the 1st frequency in the 1st touch sense mode be output to the 1st scan switching part , and the scan signal of the 1st frequency to be output through the 2nd scan switching part will be input to the 2nd impedance interface and, in the 2nd touch sense mode, the scan signal of the 1st frequency will be output to the power transmission antenna ; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit

As an embodiment, coordinate input device includes: sensing panel which is placed in the rear of display panel having multiple pixel to be driven to illustrate video images; multiple sensing strip antenna including the 1st sensing strip antenna group to be installed in sensing panel for detecting the 1st coordinate in touch input coordinate and the 2nd sensing strip antenna group for detecting the 2nd coordinate in touch input coordinate; and sensing control circuit which supplies scan signals for detecting touch input coordinate of capacitive object to the multiple sensing strip antenna for detecting touch input coordinate of capacitive object touching the front of display panel and calculates touch input coordinate based on the variation of electric property related to impedance interface of scan signal which is generated in respond to touch input coordinate of capacitive object.

As an embodiment, the sensing control circuit includes: the 1st scan switching part for selective running the 1st sensing strip antenna group; the 2nd scan switching part for selective running of the 2nd sensing strip antenna group; scan signal source generating scan signals of the 1st and 2nd frequency; the 1st impedance interface to be formed between scan signal source and the 1st scan switching part; the 2nd impedance interface to be formed between scan signal source and the 2nd scan switching part; capacitive touch detection part performing electric signal processing to detect variations of electric property related to impedance matching of scan signal of the 1st and 2nd frequencies which are loaded in the 1st and the 2nd sensing strip antenna groups at the same time; and the controller which calculates touch input coordinate of capacitive object by detecting variation of electric property related to impedance matching on scan signal of the 1st and the 2nd frequencies according to touch of capacitive object after receiving signals which have been processed through capacitive touch detection part.

As an embodiment, the capacitive touch detection part includes voltage sensor and current sensor for detecting electric property of capacitive touch scan signals.

As an embodiment, the multiple sensing strip antenna has the 1st touch sense mode running for detecting touch input of capacitive object and the 2nd touch sense mode running for detecting touch input of stylus pen embedding resonant circuit. The sensing control circuit includes: touch mode switching part running switching motion to make scan signal of the 1st frequency input in the 1st scan switching part and, at the same time, the scan signal of the 2nd frequency output to the 2nd scan switching part and, in the 2nd touch sense mode, the scan signal of the 1st frequency will be output in the 1st and 2nd scan switching parts in order; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency, are received

As an another embodiment, the touch mode switching part runs switching motion in a way that the 1st frequency signal in the 2nd touch sense mode bypasses and does not pass through the 1st impedance interface and be output to the 1st scan switching part and 2nd scan switching part in order

As an embodiment, power transmission antenna is included for transmit power to stylus pen embedding resonant circuit and the multiple sensing strip antenna as has the 1st touch sense mode operating to detect touch input of capacitive object and the 2nd touch sense mode operating to detect touch input of stylus pen. The sensing control circuit includes: touch mode switching part making switching motion so that scan signal of the 1st frequency in the 1st touch sense mode be output to the 1st scan switching part and, at the same time, the scan signal of the 2nd frequency be output to the 2nd scan switching part and, in the 2nd touch sense mode, the scan signal of the 1st frequency will be output to the power transmission antenna ; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit

As an embodiment, the power transmission antenna as mentioned has a structure that it is installed inner side of external cover which will be installed in the edge if display panel and includes magnetic cover to be installed in order to cover the power transmission antenna

As an embodiment, the sensing control circuit includes: the 1st scan switching part for selective running the 1st sensing strip antenna group; the 2nd scan switching part for selective running of the 2nd sensing strip antenna group; scan signal source generating scan signals of the 1st frequency; the 1st impedance interface to be formed between scan signal source and the 1st scan switching part; capacitive touch detection part performing electric signal processing to detect variations of electric property related to impedance matching of scan signal of the 1st frequency which is loaded in the 1st sensing strip antenna group at the same time; the 2nd impedance interface to be formed between scan signal source and the 2nd scan switching part; and the controller which calculates touch input coordinate of capacitive object by detecting variation of electric property related to impedance matching on scan signal of the 1st frequency according to touch of capacitive object after receiving signals which have been processed through capacitive touch detection part.

As an embodiment, the capacitive touch detection part includes voltage sensor and current sensor for detecting electric property of capacitive touch scan signals.

As an embodiment, the multiple sensing strip antenna has the 1st touch sense mode running for detecting touch input of capacitive object and the 2nd touch sense mode running for detecting touch input of stylus pen embedding resonant circuit. The sensing control circuit includes: touch mode switching part running switching motion to make scan signal of the 1st frequency input in the 1st scan switching part and, the scan signal of the 1st frequency output through the 2nd scan switching part input to the 2nd impedance interface and, in the 2nd touch sense mode, the scan signal of the 1st frequency will be output in the 1st and 2nd scan switching parts in order; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency, are received

As an another embodiment, the touch mode switching part runs switching motion in a way that the 1st frequency signal in the 2nd touch sense mode does not pass through the 1st impedance interface and be output to the 1st scan switching part and 2nd scan switching part in order

As an embodiment, power transmission antenna is included for transmit power to stylus pen embedding resonant circuit and the multiple sensing strip antenna as has the 1st touch sense mode operating to detect touch input of capacitive object and the 2nd touch sense mode operating to detect touch input of stylus pen. The sensing control circuit includes: touch mode switching part making switching motion so that scan signal of the 1st frequency in the 1st touch sense mode be output to the 1st scan switching part and, the scan signal of the 1st frequency output through the 2nd scan switching part input to the 2nd impedance interface and, in the 2nd touch sense mode, the scan signal of the 1st frequency will be output to the power transmission antenna; and pen touch detection part where electric signal processing is performed for detecting touch input coordinate of stylus pen by detecting electric signal from multiple sensing strip antenna in the 2nd touch sense mode. The controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit

As an embodiment, the power transmission antenna as mentioned has a structure that it is installed inner side of external cover which will be installed in the edge if display panel and includes magnetic cover to be installed in order to cover the power transmission antenna

As an embodiment, sensing panel is installed either in front or in the rear of optical sheet of backlight unit illuminating the light toward display panel from the rear of display panel

As an embodiment, sensing panel is installed either in front or in the rear of optical sheet of backlight unit illuminating the light toward display panel from the rear of display panel

As an embodiment, shielding sheet for shielding magnetic interference between circuit board which is placed on the latter part of sensing panel.

As an embodiment, shielding sheet has a single or more than two separated shielding areas.

As an embodiment, shielding sheet includes magnet layer and carbon fiber layer which are formed on the board and in a side of the substrate.

As an embodiment, multiple sensing strip antenna forms conductive film by printing processing, vapor deposition or etching process on the surface of sensing panel board.

As an embodiment, conductive bezel trace which is formed in the bezel area of sensing panel is composed by attaching conductive wire printed and insulated.

As an embodiment, magnetic cover which is to be installed in bezel areas of dual sensing plate for covering bezel trace.

### [Effect of the Invention]

The coordinate input device of this invention having improved touch sense function can much improve touch sense performance by detecting variation of electric property related to impedance matching for scan signals and calculating touch input coordinate of capacitive object

### [Brief description of drawings]

Figure 1 is a schematic view which illustrates configuration of coordinate input device according to the 1st embodiment.
Figure 2 and 3 are schematic view which illustrate the switching condition of touch mode switching part in the 1st and 2nd touch sense mode.
Figure 4 is a schematic view which illustrates that capacitive touch detection part includes voltage sensor and current sensor.
Figure 5 is a schematic view that illustrates various impedance matching circuit which can be applied to impedance matching part.
Figure 6 is a schematic view that illustrates changes of electric property of scan frequency according to existence of capacitive touch.
Figure 7 and 8 are schematic view that illustrate the structure of bypass in the touch mode switching part in the 2nd touch sense mode.
Figure 9 through 12 are schematic view that illustrate various modified structures of sensing strip antenna
Figure 13 is a schematic view that illustrates configuration of coordinate input device according to the 2nd embodiment of this invention.
Figure 14 is a schematic view that illustrates switching motion in the 1st touch sense mode for detecting capacitive touch in the 2nd embodiment.
Figure 15 is a schematic view that illustrates switching motion in the 1st touch sense mode for detecting EMR stylus pen touch in the 2nd embodiment.
Figure 16 is a schematic view that illustrates configuration of coordinate input device according to the 3rd embodiment.
Figure 17 is a schematic view that illustrates various laminated structures of sensing panel
Figure 18 and 19 are schematic view that illustrate examples of composition of sensing strip antenna by using conductive wire.
Figure 20 through 27 are schematic view that illustrate cases where sensing strip antenna can be composited by using conductive wire
Figure 28 is a schematic view that illustrates devices in which coordinate input device of this invention is installed.
Figure 29 through 32 are schematic view that illustrate example that coordinate input device of this invention is installed in the rear of display panel.
Figure 33 through 35 are schematic view that illustrate examples that magnetic cover is installed in bezel area
Figure 36 is a schematic view that illustrates example that power transmission antenna is installed inner side of external cover of display panel
Figure 37 through 41 are schematic view that illustrate various formed shielding sheet structures to be installed in coordinate input device of this invention
Figure 42 is a schematic view that illustrates example that coordinate input device and display panel taking turns in moving interactively.

**[Explanation of Code]**

| | | | |
|---|---|---|---|
| 100: | coordinate input device | 200: | sensing panel |
| 210: | sensing strip antenna | 212: | the 1st sensing strip antenna group |
| 214: | the 2nd sensing strip antenna group | 216: | power transmission antenna |
| 220: | capacitive object | 230: | stylus pen |
| 232: | resonant circuit | 240, 240a, 240b: | |
| | | | substrate |
| 245: | bonding layer | 250, 260: | sensing strip antenna |
| 270: | dielectric layer | 280: | conductive wire |
| 290: | dielectric cover | 300: | sensing control circuit |
| 312: | the 1st scan switching unit | 314: | the 2nd scan switching unit |
| 320: | scan signal supply | 322: | the 1st frequency source |
| 324: | the 2nd frequency source | 332: | the 1st impedance matching unit |
| 334: | the 2nd impedance matching unit | 340: | touch mode switching unit |
| 342: | the 1st switch | 344: | the 2nd switch |
| 350: | capacitive touch detection unit | 360: | pen touch detection unit |
| 370: | controller | 400: | host |
| 500: | display panel | 510: | cover window |
| 520: | light guide board | 522: | light source |
| 524: | optical sheet | 526: | reflecting plate |
| 530: | shield sheet | 531: | substrate |
| 532: | carbon fiber layer | 533: | magnetic layer |
| 540: | circuit board | 600, 610: | magnetic cover |

### [Best Mode for Implementation of Invention]

Exemplary embodiments of the present invention will be described with reference to the accompanying drawings in order to sufficiently understand the present invention. Exemplary embodiments of the present invention may be modified into several forms, and it is not to be interpreted that the scope of the present invention is limited to exemplary embodiments described in detail below. Exemplary embodiments are provided in order to completely explain the present invention to those skilled in the art. Therefore, shapes, or the like, of components in the accompanying drawings may be exaggerated for clarity. It is to be noted that the same components will be denoted by the same reference numerals throughout the accompanying drawings. A detailed description for the well-known functions and configurations that may unnecessarily make the gist of the present invention unclear will be omitted.

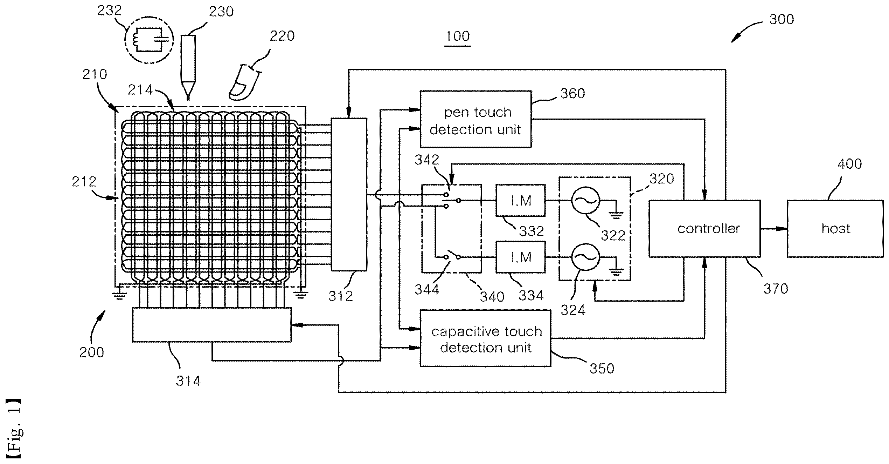

Fig. 1 is a view illustrating configuration of coordinate input device according to the 1st embodiment.

Referring to Fig. 1, coordinate input device (100) according to the 1st embodiment of this invention consists of sensing control circuit (300) which controls sensing panel (200) having multiple sensing strip antenna (210) and detects touch input and calculates relevant touch input coordinate. Coordinate input device (100) supplies san signals for detecting touch input coordinate to multiple sensing strip antenna (210). In this instance, touch input coordinate is calculated based on variations of electric property related to impedance matching of scan signals which are generated in response to touch input coordinate and supplied to the host (400).

The coordinate input device (100) of this invention provides improved touch sense performance by calculating touch input coordinate based on variations of electric property related to impedance matching of scan signals. In addition, touch input of stylus pen (230) embedding resonant circuit (232) can be also composited enough to detect touch input. In other words, a sensing control circuit (300) can be composited so as to detect all touch input of capacitive object (220) and stylus pen (230) by using single sensing panel (200) without installment of separate digitizer panel for detecting touch input of stylus pen (230)

Sensing pane (200) has multiple sensing strip antenna (210) including the 1st sensing strip antenna group (212) for detecting Y coordinate in touch input coordinate and the 2nd sensing strip antenna group (214) for detecting X coordinate in touch input coordinate. Sensing control circuit (300) has the 1st and 2nd scan switching unit (312, 314), scan signal supply (320), the 1st and 2nd impedance matching part (332, 334), capacitive touch detection part (350), and controller (370). And pen touch detection part (360) may be added for detecting touch input of stylus pen (230).

The 1st scan switching unit (312) makes scan signal selectively supplies in the 1st sensing strip antenna group (212). The 2nd scan switching unit (314) makes scan signal selectively supplies in the 2nd sensing strip antenna group (214). Scan signal supply (320) generates scan signals of the 1st frequency and 2nd frequency. Scan signal supply (320) has the 1st and 2nd frequency sources (322, 324) for generating scan signals of the 1st and 2nd frequencies. Circuit may be composed so that scan signal supply (320) can supply the scan signals of the 1st and 2nd frequencies by using single frequency source generating signals. Scan signals the 1st and 2nd frequencies may be the same or different frequency. The wave form of those frequencies may be used various wave forms including sine wave, chopping wave and square wave.

The 1st impedance matching part (332) is composed between scan signal supply (320) and the 1st scan switching part (321) and the 2nd impedance matching part (334) is composed between scan signal supply (320) and the 2nd scan switching unit (314). The 1st and 2nd impedance matching part (332, 334) is composed between scan signal supply (320) and the 1st and 2nd sensing strip antenna group (212, 214) so as to perform impedance matching

Capacitive touch detection part (350) performs electric signal processing in order to detect variation of electric property related to impedance matching of scan signals of the 1st and 2nd frequencies which are loaded respectively at the same time in the 1st and 2nd sensing strip antenna group (212, 214) and provide it to the host (400).

In order to detect all the touching input of capacitive object (220) and stylus pen (230), multiple sensing strip antenna (210) have the 1st touch sense mode for detecting touch input of capacitive object (220) and the 2nd touch sense mode for detecting touch input of stylus pen (230). And sensing control circuit (300) has touch mode switching part (340) so as to allow scan signals selectively supplied to sensing panel (200) according to the 1st and 2nd sense modes. Controller (370) control switching motion of scan signal supply (320), touch mode switching part (340), and the 1st and 2nd scan switching unit (312, 314).

Touch mode switching part (340) makes switching motion so that signal of the 1st frequency in the 1st touch sense mode be output to the 1st scan switching unit (312) and, at the same time, signal of the 2nd frequency in the 1st touch sense mode be output to the 2nd scan switching unit (314). Touch mode switching part (340) makes switching motion so that, in the 2nd touch sense detection mode, the scan signal of the 1st frequency will be output to the 1st and 2nd scan switching unit (312, 314) in order. Pen touch detection part (360) performs electric signal processing for detecting touch input coordinate of stylus pen (230) by detecting electric signal from multiple sensing strip antenna (210) in the 2nd touch sense mode. The controller (370) calculates touch input coordinate of stylus pen (230) by receiving signals which have been processed through pen touch detection part (360) in the 2nd touch sense mode and detecting whether radio frequency signals, which is transmitted from resonating of scan signals of the 1st frequency in stylus pen (230) resonant circuit (232)

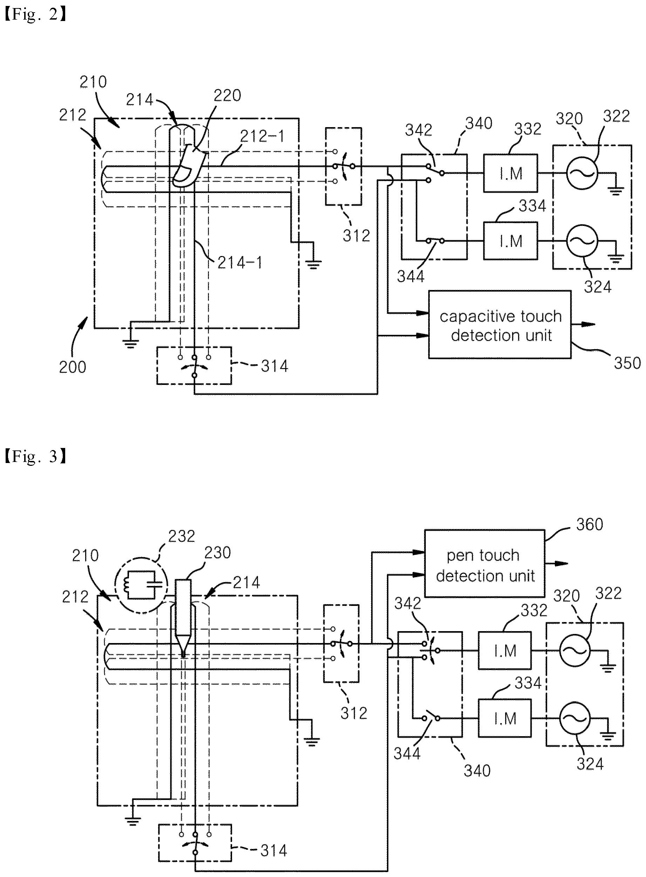

Fig. 2 and 3 are schematic view which illustrate the switching condition of touch mode switching part in the 1st and 2nd touch sense mode.

Referring to Fig. 2, the scan signal of the 1st frequency generated from the 1st frequency source (322) is output to the 1st scan switching unit (312) through the 1st impedance matching part (332) and touch mode switching part (340). At the same time, the scan signal of the 2nd frequency generated from the 2nd frequency source (324) is output to the 2nd scan switching unit (314) through the 2nd impedance matching part (334) and touch mode switching part (340). In this condition, the 1st and 2nd scan switching unit (312, 314) make switching motion in order according to respective scan cycle and supply scan signals of the 1st and 2nd frequencies to the 1st and 2nd sensing strip antenna groups (212, 214)

Likewise, in the 1st touch sense detection mode, the 1st scan switching part makes switching motion in order and scan signals of the 1st frequency will be input to a certain sensing strip antenna (212- 1) which belongs to the 1st sensing strip antenna group (212). Besides, while the 2nd scan switching unit (314) makes switching motion in order and scan signals of the 1st frequency will be input to a certain sensing strip antenna (214- 1) which belongs to the 1st sensing strip antenna group (214).

At this point, capacitive touch detection part (350) performs electric signal processing in order to detect variation of electric property related to impedance matching of scan signals of the 1st and 2nd frequencies which are loaded respectively at the same time in the 1st and 2nd sensing strip antenna group (212, 214) and provide it to the host (400).

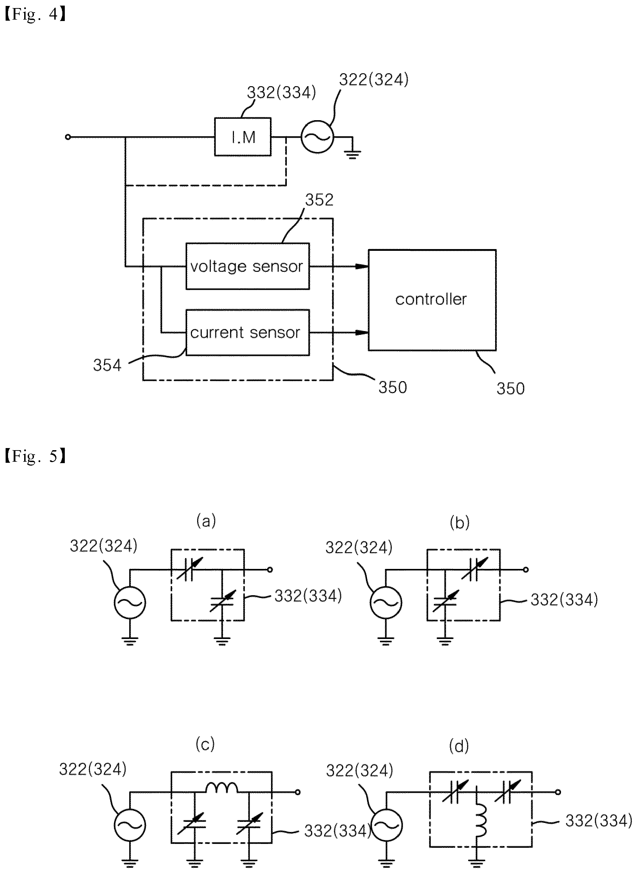

Fig. 4 is a schematic view which illustrates that capacitive touch detection part includes voltage sensor and current sensor.

Referring to Fig. 4, controller (370), decides existence of touch by detecting variation of electric property related to impedance matching based on the values input through capacitive touch detection part (350) without touch of capacitive object (220). Here, the electric property values include voltage level, voltage phase, current level, current phase and difference between voltage and current phase. Capacity touch detection part (350) has voltage sensor (352) and current sensor (354) for detecting variation of electric property according to the existence or nonexistence of touch of capacitive object (220).

As a way of detecting variation of electric property, such variation may be measured by controller (370) from measuring voltage value and current value measured by voltage sensor (352) and current sensor (354). Or, a circuit may be organized to compare electric properties in capacity touch detection part so that the result of such comparison can be send to the controller. For example, by installing differential amplifier, which can compare input and output of scan signals, compared signals

Fig. 5 is the drawing that illustrates various impedance matching circuit which can be applied to impedance matching part.

Referring to Fig. 5, the 1st and 2nd impedance matching part (332, 334) may be used by various formed impedance matching circuits. According to resonance design method, L matching network, T matching network and Pi matching network. In organizing resonant circuit, various type or fixed type capacity or inductor and, as for connection structure, series structure and parallel structure may be used. In making resonance design, capacitive object may be allowed to have maximum value while capacitive object is either not touched or touched.

Here, making capacity object have maximum value while capacitive object is not touched means that: initial design is to be made to make it have maximum value and it will have smaller value when a touch is made by capacitive object because the condition of resonance cannot be satisfied. In addition, making it have maximum value while capacitive object is touched means that: resonant design is to be made by measuring capacitive capacity of capacitive object and, when a touch is generated by capacitive object, such condition is satisfied and it has maximum value.

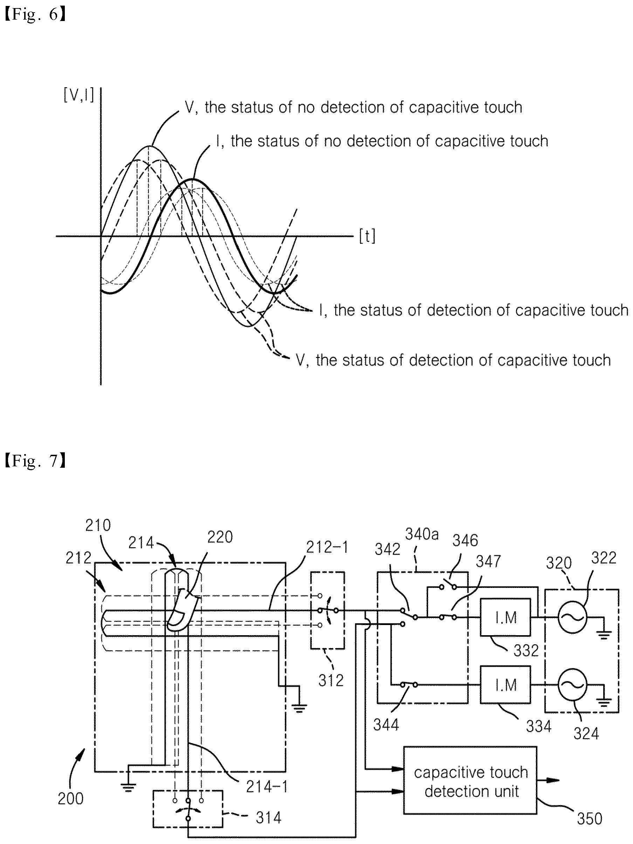

Fig. 6 is the drawing that illustrates changes of electric property of scan frequency according to existence or nonexistence of capacitive touch.

Referring to Fig. 6, if impedance matching is made based on the condition that capacity object (220) is not touched and when capacitive object (220) is touched, electric property of scan signal of the 1st and 2nd frequencies will be changed in terms of impedance matching. For example, the level and phase of voltage and current may change and the difference in voltage and current phases may change.

For example, referring to Fig. 2, if the scan signal of the 1st and 2nd frequencies is input to the 1st and 2nd sensing strip antenna group (212, 214) in the 1st touch sense mode and when touch input is made in capacitive object (220), impedance will be changed. This changes in electric property will be detected at the point that certain sensing strip antenna (212-1, 214- 1), which is related to the area where capacitive object (220) is touched, is driven. Thus the existence and non- existence of touch to capacitive object (220) can be detected and, at that point, touch input coordinate can be calculated according to such specific sensing strip antenna (212- 1, 214- 1).

Again, referring to Fig. 3, coordinate input device (100) of this invention can touch input of stylus pen (230) embedding resonant circuit (232) by using a single and same sensing panel (200). In order to detect stylus pen (230), sensing panel (200) moves as the 2nd touch detection mode. The touch mode switching part (340) in the 2nd touch detection mode makes switching motion so that the scan signal of the 1st frequency which is generated in the 1st frequency source (332) will be output to the 1st and 2nd scan switching part. And, the 1st and 2nd sensing strip antenna group (212, 214) also make its switching motion for driving multiple sensing strip antenna in order. For example, a scan motion to the 1st sensing strip antenna group (212) is completed by the 1st scan switching part (312) and, thereafter, a scan motion to the 2nd sensing strip antenna group (214) will be completed by the 2nd scan switching unit (314).

Multiple sensing strip antenna (210) in the 2nd touch detection mode has sending antenna function and receiving antenna function. In other words, multiple sensing strip antenna (210) is driven in order according to scan motion and output scan signal of the 1 frequency wirelessly and moves to receive radio signals which are resonated and sent in resonance circuit (232) of stylus pen (230. By receiving processed signals through pen touch detection part, Controller (370) detects the receipt or not of radio frequency signals which are transmitted by resonated scan signals of the 1st frequency in resonant circuit (232) of stylus pen (230) and calculates touch input coordinate of stylus pen.

Likewise, coordinate input device (100) of this invention can realize improved touch detection performance by detecting touch input of capacitive object (220) by using impedance matching circuit. Also, by using conversion function of the single and same sensing panel and touch detection mode, it can detect all the touch input of capacitive object (220) and touch input of stylus pen (230) embedding resonant circuit (232)

### [Mode for Implementation of Invention]

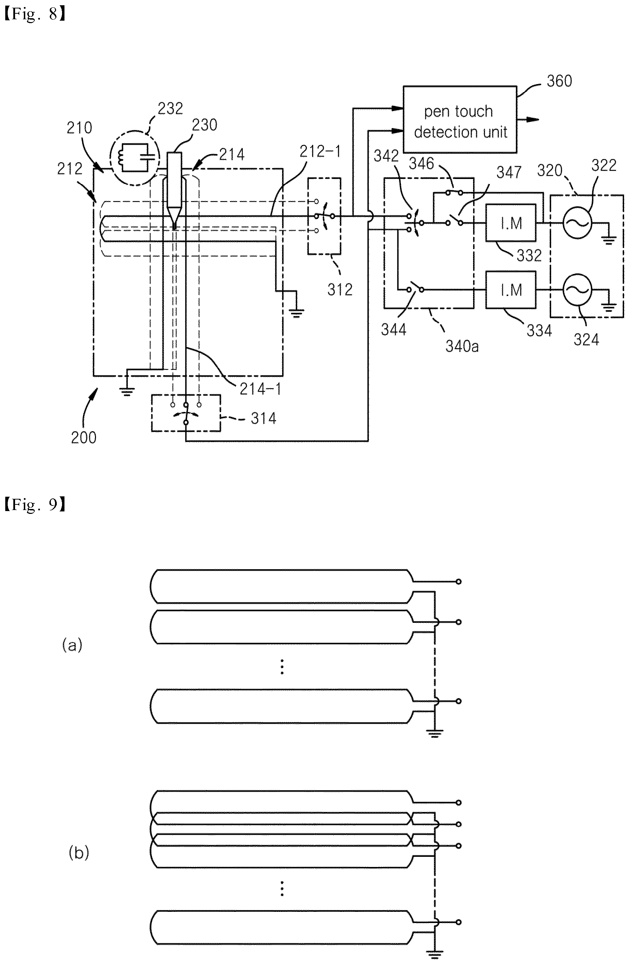

Fig. 7 and 8 are the drawings that illustrate the structure of by- pass in the touch mode switching part in the 2nd touch sense mode.

Referring to Fig. 7 and 8, the scan signals generated from the 1st frequency source (322) for detecting touch input of stylus pen (230) embedding resonant circuit (232) bypass and not going through the 1st impedance matching part (322) until they can be supplied to the 1st and 2nd scan switching unit (312, 314). Touch mod switching part (346) may have more switches (346, 347) which cannot bypass in the 1st touch detection mode but can bypass at the 2nd touch detection mode.

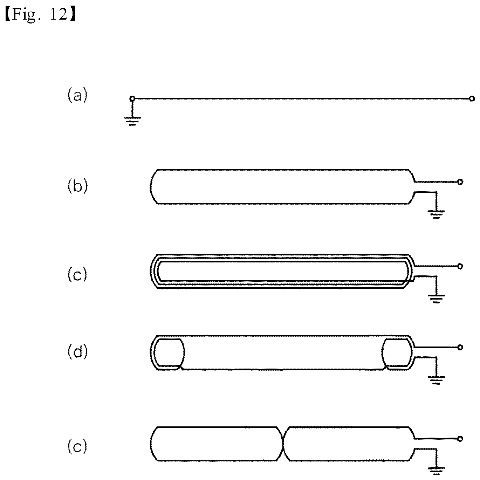

Fig. 9 through 12 are the drawings that illustrate various modified structures of sensing strip antenna

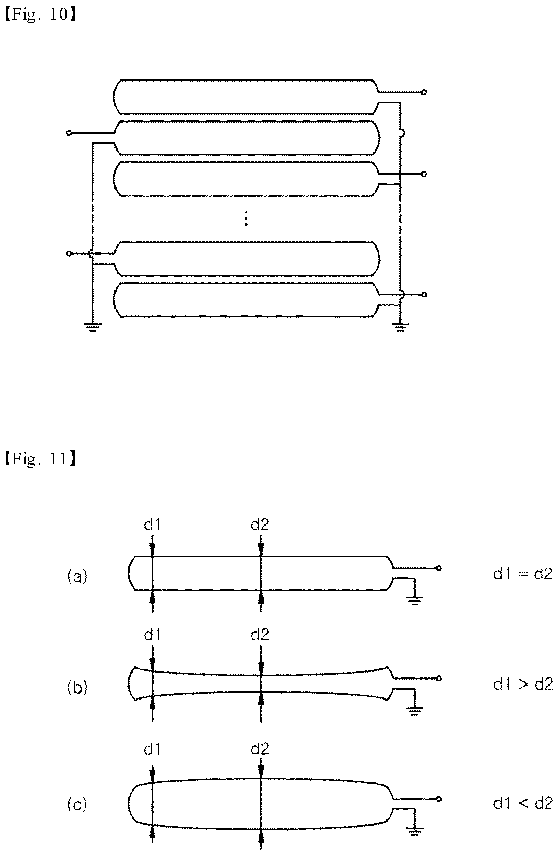

Referring to Fig. 9 through 12, sensing strip antenna of coordinate input device (100) of this invention may be realized in various ways. For example, as illustrated in Fig. 9, it can be realized in one- turn and nonoverlapping form or one- turn and overlapping form. Or, as illustrated in Fig. 10, scan signals can be placed to be symmetrically input by turns. And, as illustrated in Fig. 11, the width of sensing strip antenna in one-turn form may be identical or different in their entire length. Such width may be differentiated so that the density of electromagnetic field of sensing antenna strip be uniform

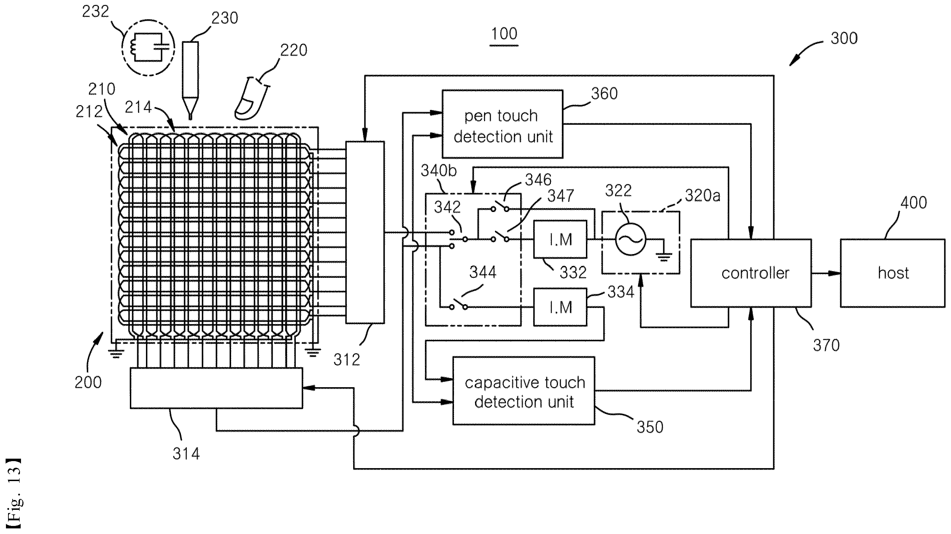

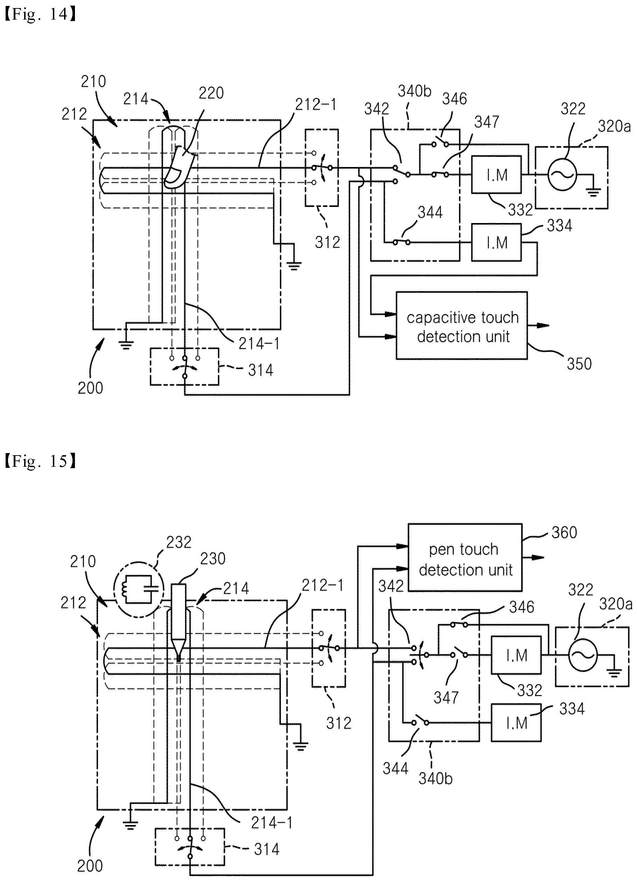

Fig. 13 is the drawing that illustrates configuration of coordinate input device according to the 2nd embodiment of this invention. Fig. 14 is the drawing that illustrates switching motion in the 1st touch sense mode for detecting capacitive touch in the 2nd embodiment. And, Fig. 15 is the drawing that illustrates switching motion in the 1st touch sense mode for detecting EMR stylus pen touch in the 2nd embodiment.

Referring to Fig. 13, the 2nd embodiment of this invention has almost the same composition with those of the 1st embodiment and repetitive explanation of such same composition is omitted. The coordinate input device (100) according to the 2nd embodiment uses only one frequency source (322) as scan signal supply(320a). In the 1st touch detection mode, touch mode switching part (340) makes the scan signal of the 1st frequency supplied to the 1st scan switching part unit (312) through the 1st impedance matching part (332), and makes the 2nd impedance matching part (334) connected with the 2nd scan switching unit (314). Thus the controller (370) in the 1st touch detection mode detects variation of electric property related to impedance matching to the scan signal of the 1st frequency according to the existence/non- existence of touch of capacitive object (220) and calculates touch input coordinate of capacitive object (220). The motion in the 2nd touch detection mode is the same with that in the 1st embodiment.

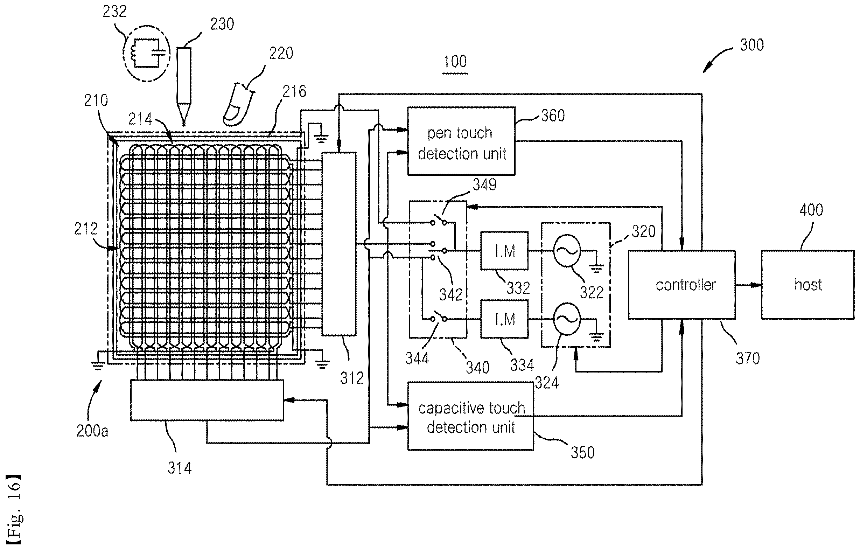

Fig. 16 is the drawing that illustrates configuration of coordinate input device according to the 3rd embodiment.

Referring to Fig. 16, the coordinate input device (100) of this invention according to the 3rd embodiment is almost the same with those of the 1st and 2nd embodiments. Thus repetitive explanation of such same composition is omitted. The coordinate input device (100) of this invention according to the 3rd embodiment may have separate power transmission antenna (216) for resonation of stylus pen (230) embedding resonant circuit (232). Power transmission antenna (216) moves in the 2nd touch detection mode. Touch mode switching part (340) is switched so that the scan signals of the 1st frequency can be supplied to the power transmission antenna (216). In other words, the 1st and 2nd sensing strip antenna group (212, 214) functions only as receiving antenna.

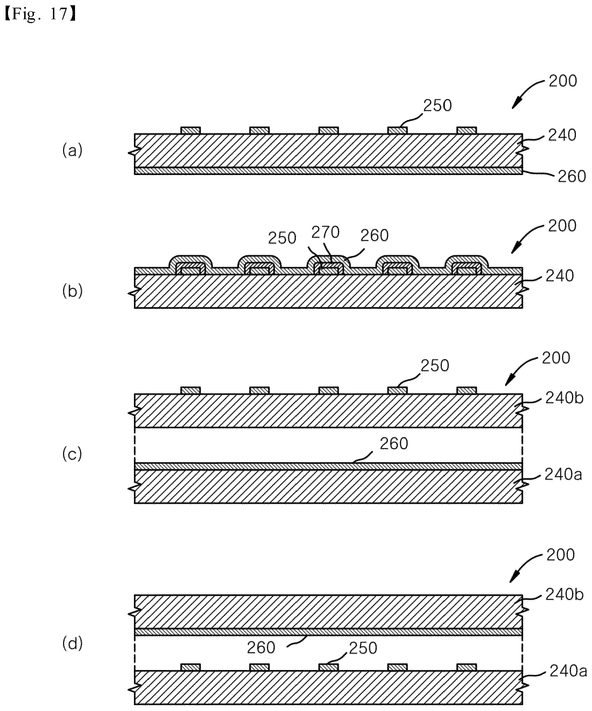

Fig. 17 is the drawing that illustrates various laminated structures of sensing panel

Referring to Fig. 17, lamination layer structure of sensing panel (200) may be realized in various forms. For example, as illustrated in Fig. 17(a), it may have a structure where sensing strip antenna (250, 260) is laminated in both side of the single substrate (240). A side of single substrate (240) can be laminated by the 1st sensing strip antenna group (250) and the other side of it can be laminated by the 2nd sensing strip antenna group (260). Or as illustrated in Fig. 17(b), the structure may be that a side of single substrate (240) can be laminated by the 1st and 2nd sensing strip antenna groups (250, 260) across dielectric layer (270).

As illustrated in Fig. 17(c), the structure may be that two sheets of substrate (240a, 240b) can be laminated by the 1st and 2nd sensing strip antenna (250, 260), respectively and those two sheets of substrate (240a, 240b) are glued with each other. Or, as illustrated in Fig. 17(d), the structure may be that, in each one side of two sheets of substrate (240a, 240b) facing with each other, the 1st and 2nd sensing strip antenna (250, 260) can be laminated and those two sheets of substrate (240a, 240b) are glued with each other. In this case, such glue can be functioned as insulation layer. As, the sensing penal (200) of coordinate input device (100) of this invention can be manufactured in various lamination layer. Sensing strip antenna (250, 260) is made of transparent electric conductor such as ITO or opaque electric conductor such as copper and silver. Transparent or opaque materials may be also used for the substrate (240).

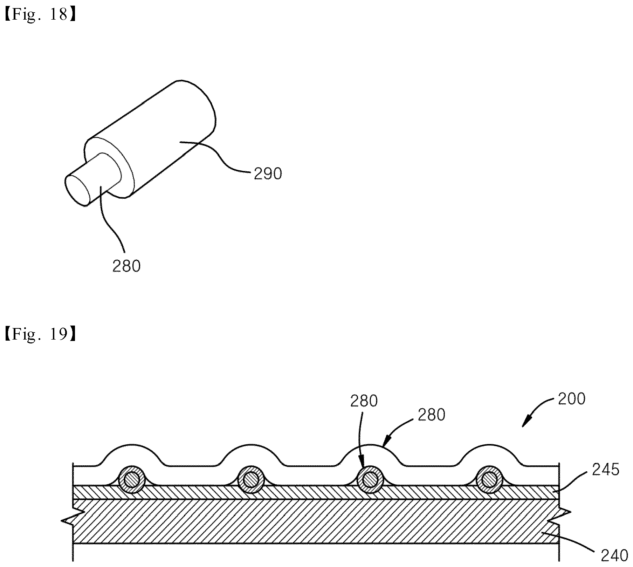

Fig. 18 and 19 are the drawings that illustrate examples of composition of sensing strip antenna by using conductive wire.

Referring to Fig. 18 and 19, sensing strip antenna laminated in sensing panel (200) of this invention may be organized by being glued in a side of the substrate (240) having lamination layer of conductive wire (280). In case of using conductive wire (280) coated external part of dielectric layer (290), separate insulation layer may not be needed. In case of organizing multiple sensing strip antenna by using conductive wire (280), various lamination layer structure can be realized as explained by referring to Fig. 17.

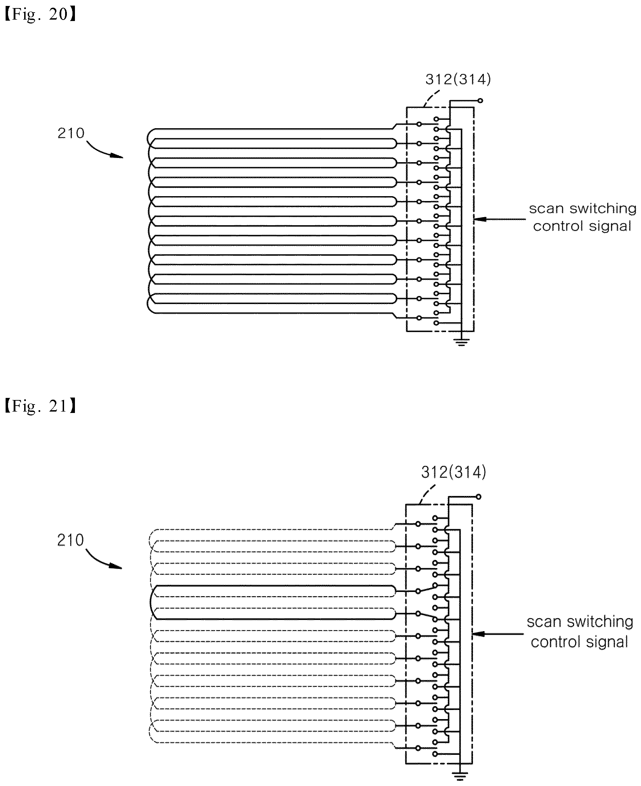

Fig. 20 through 27 are the drawings that illustrate cases where sensing strip antenna can be composited by using conductive wire

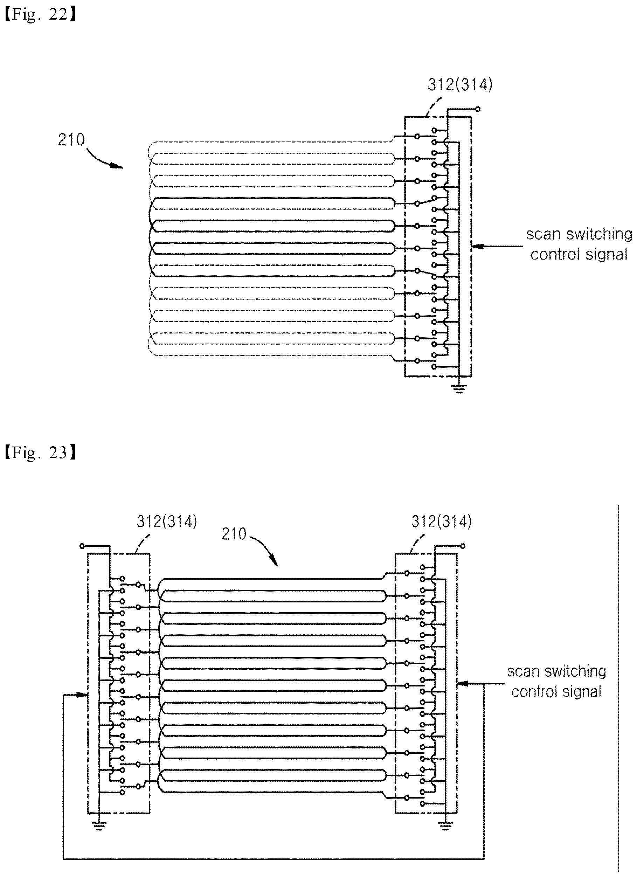

Referring to Fig. 20 through 25, connected conductive wires may be used for the case of organizing sensing strip antenna (210) by using conductive wire. For example, conductive wires may be arranged into an overlapped helix shape and tap is organized in each column of such helix structure to be connected with scan switching unit (312, 314). The tap organized in each column is to be organized to be switching between node where scan signals is input and the node which is connected to grounding. For example, as illustrated in Fig. 21 and 22, the structure may be organized that the tap in certain section is switched according to the controlling signal of scan switching so that the scan signals can be loaded.

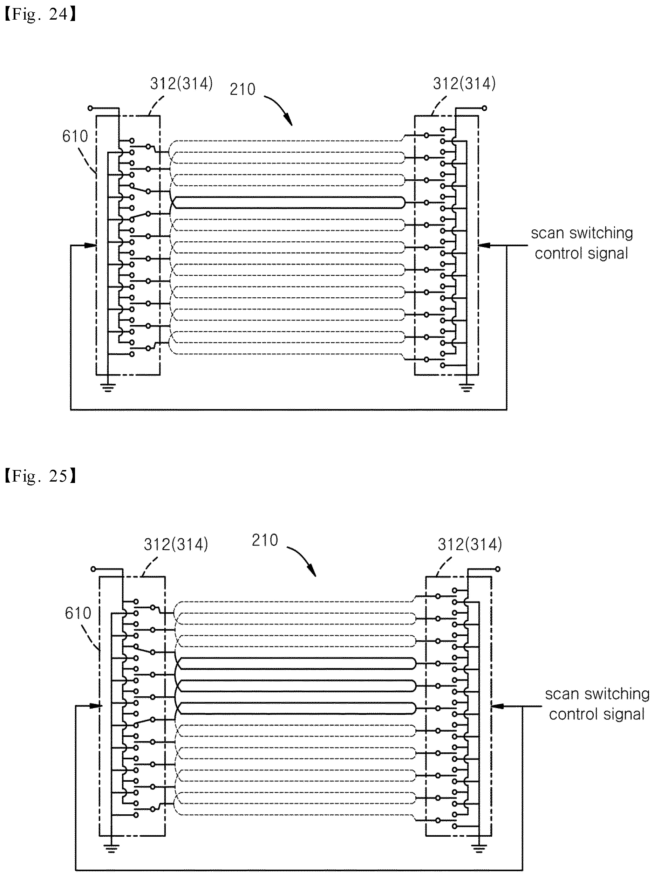

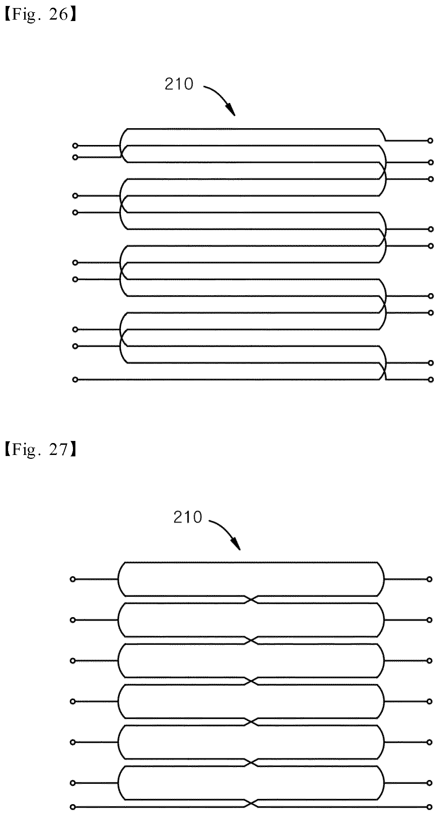

In Fig. 23, a modified structure is illustrated that multiple tap is organized in both edges of conductive wire which are overlapped and arranged in helix shape and, in Fig. 24 and 25 illustrate that the tap in certain section is switched according to the controlling signal of scan switching so that the scan signals can be loaded. In addition, as illustrated in Fig. 26, the sensing strip antenna (210) can be organized by arranging to be overlapped in parallel helix structure. As illustrated in Fig. 27, it can be organized by a single conductive wire so that it can intersect in the middle part.

Likewise, if the sensing strip antenna (210) is organized by using connected conductive wire and multiple taps in a way that such antenna is glued to the substrate, costs for materials and manufacture can be significantly saved. Besides, the resistance of sensing strip antenna (210) can be lowered and sensing level can be improved.

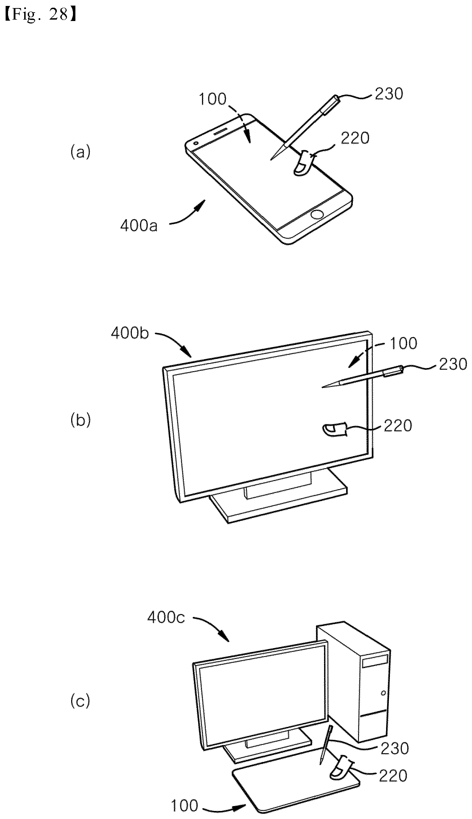

Fig. 28 is the drawing that illustrates devices in which coordinate input device of this invention is installed.

Referring to 28, various devices can be installed in coordinate input device (100) of this invention including coordinate input device (100) installed in smart phone(400a), coordinate input device (100) installed in monitor(400b), and coordinate input device (100) installed in for personal computer(400c)

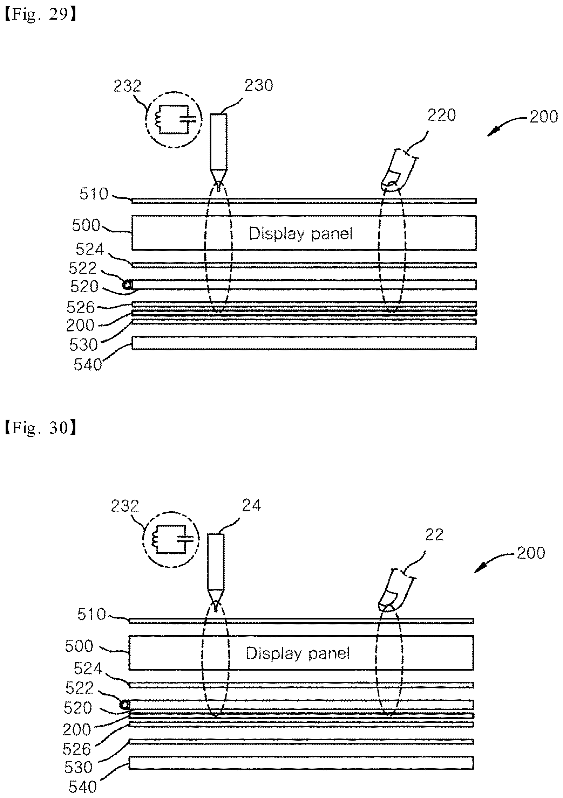

Fig. 29 through 32 are the drawings that illustrate examples that coordinate input device of this invention is installed in the rear of display panel.

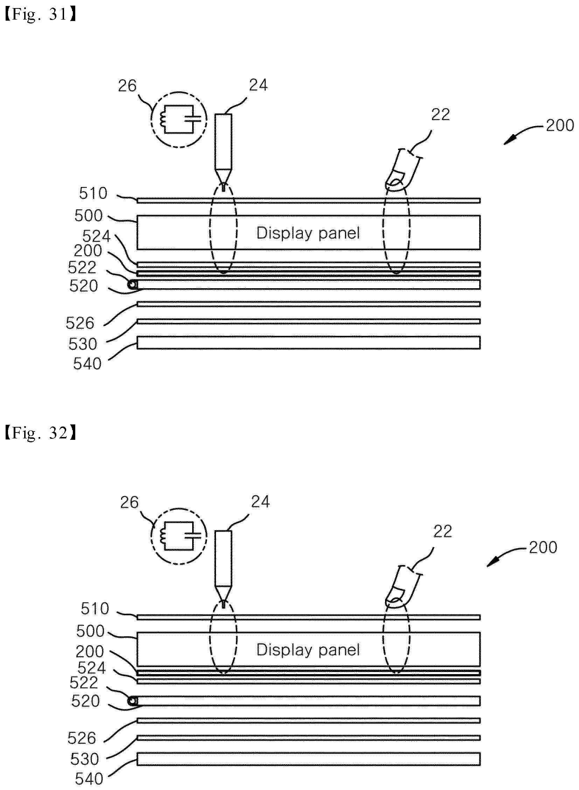

Referring to Fig. 29 through 32, in particular, coordinate input device (100) of this invention has higher performance in touch detecting to capacitive object (220) and sensing panel (200) can be installed in the rear of display panel (500). In general, cover window (510) is installed (or may be omitted) in the front of display panel (500) because display panel is equipped with multiple pixels to be driven to present video images and light guide panel (520), which forms back light unit, is installed in the rear of display panel. Light guide panel (520) is equipped with edge-typed or direct- typed light source (522). In general, optical sheet (524) is installed in the front of light guide panel (520) and reflecting plate (526) is installed in the rear of it. And, in the rear of back light unit, circuit board (540) of devices is installed. Sensing panel (200) can be placed in the rear of this display panel (500) and, for example, as illustrated in Fig. 29 and 30, it can be installed in either in the front or rear of reflecting plate (526). Or, as illustrated in Fig. 31 and 32, it can be installed in the front or rear of optical sheet (524)

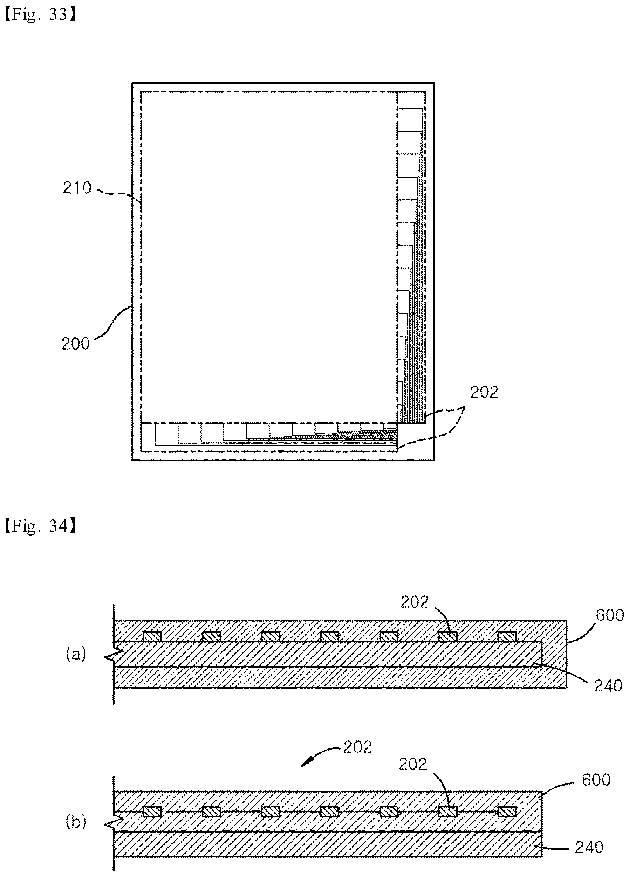

Fig. 33 through 35 are the drawings that illustrate examples that magnetic cover is installed in bezel area

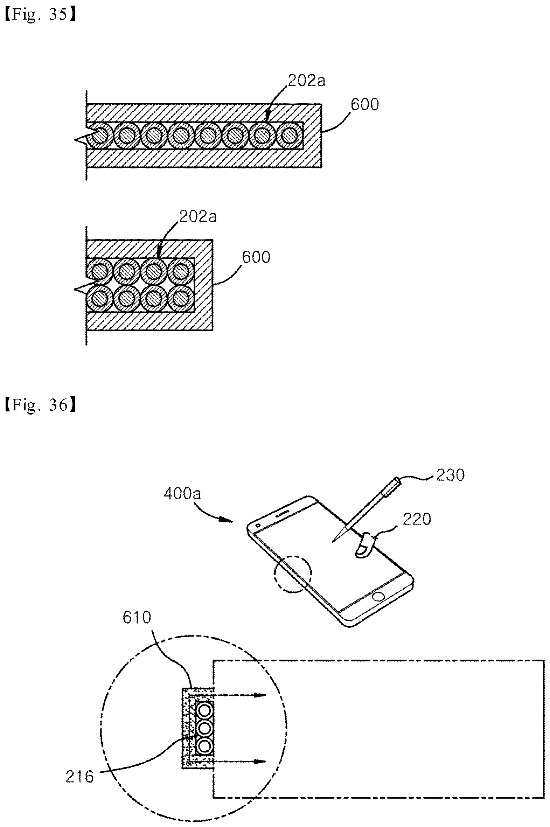

Referring to Fig. 33 through 35, coordinate input device (100) of this invention can install magnetic cover (600) in bezel trace (202), which is placed in bezel area of sensing panel (210) so that magnetic shield can be made. Magnetic shield effect can be raised by installing magnetic cover (600) because bezel traces, conductive line, are intensely arranged. As illustrated in Fig. 35, if insulated conductive wire is used for bezel trace (202), bezel traces (202) can be organized in a single or multiple layers.

Fig. 36 is the drawing that illustrates example that power transmission antenna is installed inner side of external cover of display panel

Referring to Fig. 36, in order to raise installation effectiveness, power transmission antenna (216) can be installed inner side of external cover of display panel and, at that point, magnetic cover (610) may be installed to raise radio wave efficiency.

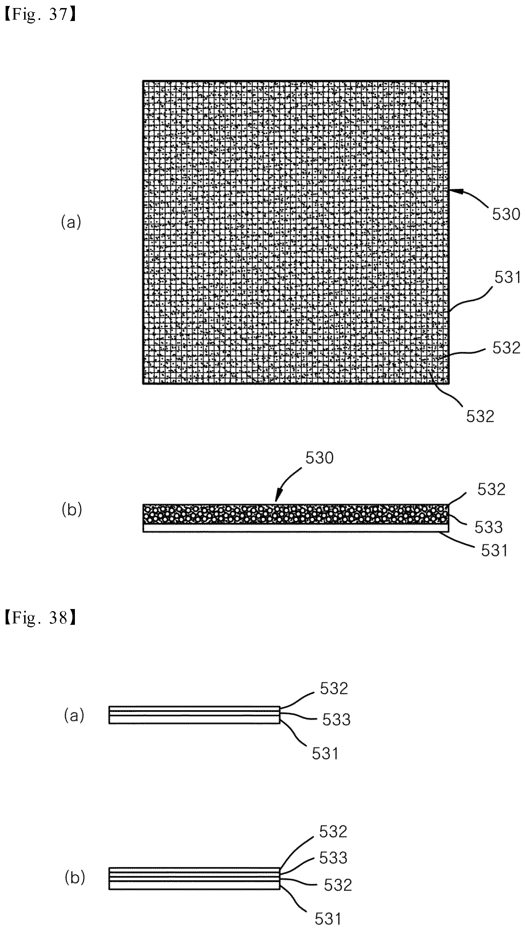

Fig. 37 and 38 are the drawings that illustrate examples of shielding sheet which can be used with coordinate input devices of this invention

Referring to Fig. 37 and 38, shield sheet (530) is to be organized to block mutual interference of noise from electromagnetic wave between circuit board (540) which is placed in the rear of sensing panel (210) and, in a side of such substrate (531) in such shield sheet, magnetic layer (533) may be organized and carbon fiber layer (532) can be organized on the top of it. Or, carbon fiber layer (532) and magnetic layer (533) may be organized with mixed form. Or, carbon fiber layer (532) may be organized to be placed in both side of magnetic layer (533) on the substrate (531). The substrate (531) may be made of metal plate or polyacrylic.

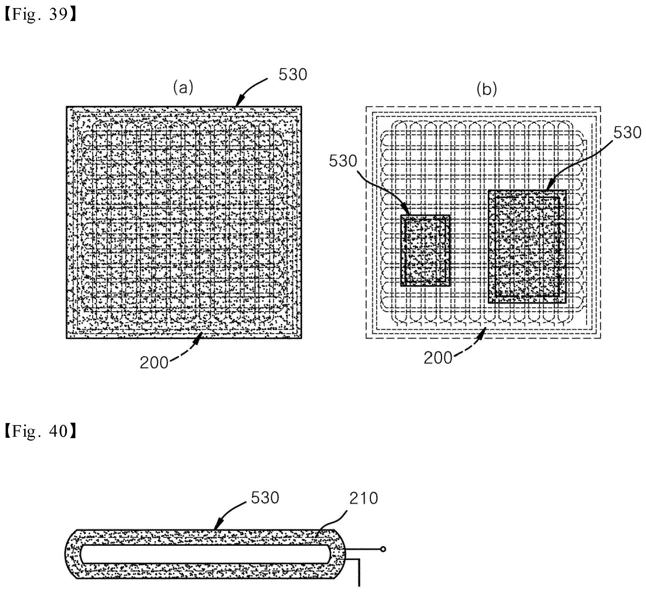

Fig. 39 through 41 are the drawings that illustrate various formed shielding sheet structures to be installed in coordinate input device of this invention

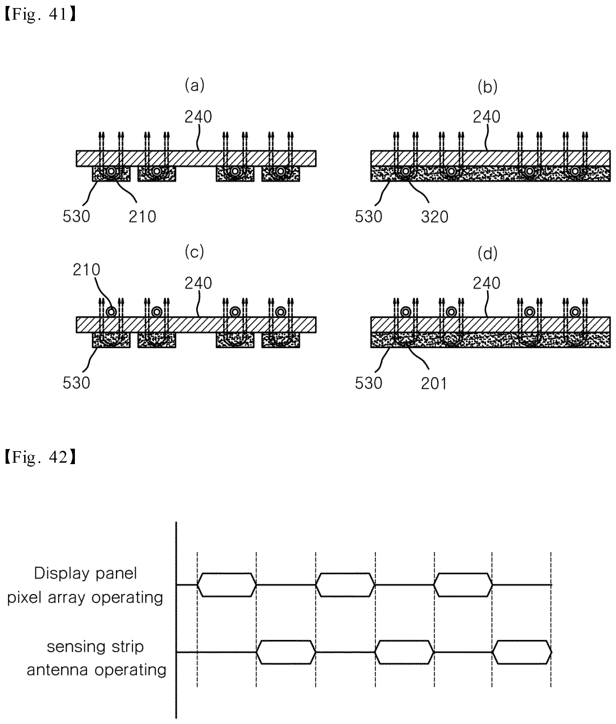

Referring to Fig. 39 through 41, as illustrated in Fig. 39, the shield sheet (530) for magnetic shield may be manufactured and installed in the same size of sensing panel (200) or be installed by divided and arranged in certain part of circuit board. Or, as illustrated in Fig. 40, it can be partially installed according to the shape of the sensing strip antenna (210). Or, as illustrated in Fig. 41, it can be organized in a form that it is glued in a side of the substrate (240) of sensing panel (210).

Fig. 42 is the drawing that illustrates example that coordinate input device and display panel taking turns in moving interactively.

Referring to Fig. 42, in order to minimize mutual interference of coordinate input device (100) of this invention and display panel (500), each driving cycle of them may be run in turns so that touch detection performance of coordinate input device (100) can be improved.

If it is organized only for detecting touch input of capacitive object (200), the coordinate input device (100) of this invention may be called as touch screen device, term commonly used. And, if it is organized to detect all the touch input from capacitive object (220) and stylus pen (230), it can be named as digitizer (or tablet). all the devices such as touch screen and tablet are devices for coordinate input and they can be used to name the coordinate input device of this invention

The embodiments of coordinate input device of this invention, which has improved touch detection performance as explained above are only examples and any person having common knowledge of the technical field which this invention belongs to would be able to be well aware that various modification and equivalent other embodiments are available from them. Thus, he or she would be able to understand that this invention is not to be limited to the form as described in the detailed explanation above. Thus, the scope of genuine technical protection of this invention must be decided by the technical idea within the scope of patent Claim as attached hereto. In addition, it must be considered that this invention includes all its derivatives, equivalence and substitutes within the spirit of this invention to be defined by such Claim scope attached.

## Claims

1. An apparatus for the coordinate input device with advanced touch sensing, comprising;
a multiple sensing strip antenna which includes the 1st sensing strip antenna group for detecting the 1st coordinate in touch input coordinate and the 2nd sensing strip antenna group for detecting the 2nd coordinate in touch input coordinate;
a sensing control circuit which supplies scan signals for detecting touch input coordinate of capacitive object to multiple sensing strip antenna and calculates touch input coordinate based on variations of electric property related to impedance matching of such scan signals which generates in response to touch input of capacitive object.

2. The apparatus for the coordinate input device with advanced touch sensing of claim 1, wherein the 1st scan switching unit for selectively driving the 1st sensing strip antenna group;
the 2nd scan switching unit for selectively driving the 2nd sensing strip antenna group;
a scan signal source generating scan signals of the 1st and 2nd frequencies;
the 1st impedance matching unit which is organized between the scan signal source and the 1st scan switching unit;
the 2nd impedance matching unit which is organized between the scan signal source and the 2nd scan switching unit;
a capacitive touch detection unit which performs electric signal processing for detecting variation of electric property related to impedance matching of scan signals of the 1st and 2nd frequency which are respectively loaded in the 1st and 2nd sensing strip groups, respectively; and
the controller which calculates touch input coordinate of capacitive object by receiving signals which have been processed through capacitive touch detection unit and detecting variation of electric property related to impedance matching of scan signals of the 1st and 2nd frequency according to existence /non- existence of touch of capacitive object.

3. The apparatus for the coordinate input device with advanced touch sensing of claim 2, wherein the voltage sensor and current sensor to detect of the scan signal of capacitive touch.

4. The apparatus for the coordinate input device with advanced touch sensing of claim 2, wherein the 1st touch sense mode running for detecting touch input of capacitive object and the 2nd touch sense mode running for detecting touch input of stylus pen embedding resonant circuit;
touch mode switching so that: in the 1st touch detection mode, scan signal of the 1st frequency is out put into the 1st scan switching part and, at the same time, the scan signal of the 2nd frequency is output in the 2nd scan switching part;
and, in the 2nd touch detection mode, the scan signal of the 1st frequency will be output to the 1st and 2nd scan switching parts in order; and
a pen touch detection unit where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency, are received.

5. The apparatus for the coordinate input device with advanced touch sensing of claim 4, wherein the switching motion in a way that the 1st frequency signal in the 2nd touch sense mode is bypassed and does not pass through the 1st impedance interface and be output to the 1st scan switching unit and 2nd scan switching unit in order.

6. The apparatus for the coordinate input device with advanced touch sensing of claim 2, wherein the power transmission antenna is included for transmit power to stylus pen embedding resonant circuit; and
the multiple sensing strip antenna as has the 1st touch sense mode operating to detect touch input of capacitive object and the 2nd touch sense mode operating to detect touch input of stylus pen; and
the sensing control circuit comprising:
a touch mode switching unit making switching motion so that scan signal of the 1st frequency in the 1st touch sense mode be output to the 1st scan switching unit and, at the same time, the scan signal of the 2nd frequency be output to the 2nd scan switching unit and, in the 2nd touch sense mode, the scan signal of the 1st frequency will be output to the power transmission antenna;
and a pen touch detection part where electric signal processing is performed for detecting touch input coordinate of stylus pen by detecting electric signal from multiple sensing strip antenna in the 2nd touch sense mode;
and the controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit.

7. The apparatus for the coordinate input device with advanced touch sensing of claim 1, wherein the 1st scan switching unit for selectively driving the 1st sensing strip antenna group;
the 2nd scan switching unit for selectively driving the 2nd sensing strip antenna group;
the scan signal source supplying scan signals of the 1st frequencies;
the 1st impedance matching unit which is organized between the scan signal source and the 1st scan switching unit;
the capacitive touch detection unit which performs electric signal processing for detecting variation of electric property related to impedance matching of scan signals of the 1st frequency which are respectively loaded in the 1st sensing strip antenna group;
the 2nd impedance matching unit which is organized between scan signal source and the 2nd scan switching unit; and
the controller which calculates touch input coordinate by receiving signals which have been processed through capacitive touch detection part and detecting variation of electric property related to impedance matching of scan signals of the 1st frequency according to existence /non- existence of touch of capacitive object.

8. The apparatus for the coordinate input device with advanced touch sensing of claim 7, wherein the voltage sensor and current sensor in order to detect electric property of scan signal of the capacitive touch.

9. The apparatus for the coordinate input device with advanced touch sensing of claim 7, wherein the multiple sensing strip antenna as has the 1st touch sense mode operating to detect touch input of capacitive object and the 2nd touch sense mode operating to detect touch input of stylus pen; and
the touch mode switching unit switching so that scan signal of the 1st frequency in the 1st touch sense mode be output to the 1st scan switching part and the scan signal of the 1st frequency, which is output through the 2nd scan switching part will be input to the 2nd impedance matching part and, in the 2nd touch detection sense mode, the scan signal of the 1st frequency be output to the 1st and 2nd scan switching parts in order; and
the pen touch detection part where electric signal processing is performed for detecting touch input coordinate of stylus pen by detecting electric signal from multiple sensing strip antenna in the 2nd touch sense mode;
and the controller calculates touch input coordinate of stylus pen by receiving signals which have been processed through pen touch detection unit in the 2nd touch sense mode and detecting whether radio frequency signals, which is transmitted from resonating of scan signals of the 1st frequency in stylus pen resonant circuit.

10. The apparatus for the coordinate input device with advanced touch sensing of claim 7, wherein the switching motion in a way that the 1st frequency signal in the 2nd touch sense mode bypasses and does not pass through the 1st impedance interface and be output to the 1st scan switching part and 2nd scan switching part in order.

11. The apparatus for the coordinate input device with advanced touch sensing of claim 7, wherein the power transmission antenna is included for transmit power to stylus pen embedding resonant circuit; and
the multiple sensing strip antenna as has the 1st touch sense mode operating to detect touch input of capacitive object and the 2nd touch sense mode operating to detect touch input of stylus pen; and
the touch mode switching part making switching motion so that scan signal of the 1st frequency in the 1st touch sense mode be output to the 1st scan switching part and, the scan signal of the 1st frequency, which is output through the 2nd scan switching part will be input to the 2nd impedance matching part and, in the 2nd touch detection sense mode, the scan signal of the 1st frequency will be output to the power transmission antenna;
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit.

12. The apparatus for the coordinate input device with advanced touch sensing comprising:
a multiple sensing strip antenna including the 1st sensing strip antenna group for detecting the 1st coordinate in touch input coordinate; and the 2nd sensing strip antenna group for detecting the 2nd coordinate in touch input coordinate;
a sensing panel including conductive wire, which is component of multiple sensing strip antenna and the substrate to which the conductive wire is glued with adhesive; and
a sensing control circuit which supplies scan signals to multiple sensing strip antenna so as to detect touch input coordinate of capacitive object and calculates touch input coordinate based on the variation of electric property related to impedance matching of scan signals, which are generated in response to touch input coordinate of capacitive object.

13. The apparatus for the coordinate input device with advanced touch sensing of claim 12, wherein the different and connected conductive wires; and
the multiple taps to be connected to such conductive wires.

14. The apparatus for the coordinate input device with advanced touch sensing of claim 12, wherein the 1st scan switching parts for selectively driving the 1st sensing strip antenna group;
the 2nd scan switching parts for selectively driving the 2nd sensing strip antenna group;
the scan signal source supplying scan signals of the 1st and 2nd frequencies;
the 1st impedance matching part which is organized between scan signal source and the 1st scan switching parts;
the 2nd impedance matching part which is organized between scan signal source and the 2nd scan switching parts;
the capacitive touch detection part which performs electric signal processing for detecting variation of electric property related to impedance matching of scan signals of the 1st and 2nd frequencies which are respectively loaded in the 1st and 2nd sensing strip antenna groups; and
the controller which calculates touch input coordinate of stylus pen by receiving signals which have been processed through capacitive touch detection part and detecting variation of electric property related to impedance matching of scan signals of the 1st frequency according to existence /non- existence of touch of capacitive object.

15. The apparatus for the coordinate input device with advanced touch sensing of claim 14, wherein the voltage sensor and current sensor in order to detect electric property of scan signal of capacitive touch.

16. The apparatus for the coordinate input device with advanced touch sensing of claim 14, wherein the 1st touch sense mode running for detecting touch input of capacitive object and the 2nd touch sense mode running for detecting touch input of stylus pen embedding resonant circuit;
the touch mode switching part running switching motion so that: in the 1st touch detection mode, scan signal of the 1st frequency is out put into the 1st scan switching part and, at the same time, the scan signal of the 2nd frequency is output in the 2nd scan switching part; and, in the 2nd touch detection mode, the scan signal of the 1st frequency will be output to the 1st and 2nd scan switching parts in order;
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency, are received.

17. The apparatus for the coordinate input device with advanced touch sensing of claim 16, wherein the switching motion in a way that the 1st frequency signal in the 2nd touch sense mode bypasses and does not pass through the 1st impedance interface and be output to the 1st scan switching part and 2nd scan switching part in order.

18. The apparatus for the coordinate input device with advanced touch sensing of claim 14, wherein the power transmission antenna is included for transmit power to stylus pen embedding resonant circuit;
the multiple sensing strip antenna as has the 1st touch sense mode operating to detect touch input of capacitive object and the 2nd touch sense mode operating to detect touch input of stylus pen;
the touch mode switching part making switching motion so that, in the 1st touch sense mode, the scan signal of the 1st frequency be output to the 1st scan switching part and, at the same time, the scan signal of the 2nd frequency be output to the 2nd scan switching part and, in the 2nd touch sense mode, the scan signal of the 1st frequency will be output to the power transmission antenna;
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit.

19. The apparatus for the coordinate input device with advanced touch sensing of claim 12, wherein the 1st scan switching parts for selectively driving the 1st sensing strip antenna group;
the 2nd scan switching parts for selectively driving the 2nd sensing strip antenna group;
the scan signal source supplying scan signals of the 1st frequency; the 1st impedance matching part which is organized between scan signal source and the 1st scan switching parts;
the capacitive touch detection part which performs electric signal processing for detecting variation of electric property related to impedance matching of scan signals of the 1st frequency which are loaded in the 1st sensing strip antenna group;
the 2nd impedance matching part which is organized between the 2nd scan switching parts and capacitive detection part and;
the controller which calculates touch input coordinate of stylus pen by receiving signals which have been processed through capacitive touch detection part and detecting variation of electric property related to impedance matching of scan signals of the 1st frequency according to existence /non- existence of touch of capacitive object.

20. The apparatus for the coordinate input device with advanced touch sensing of claim 19, wherein the voltage sensor and current sensor in order to detect electric property of scan signal of capacitive touch.

21. The apparatus for the coordinate input device with advanced touch sensing of claim 19, wherein the multiple sensing strip antenna as has the 1st touch sense mode operating to detect touch input of capacitive object and the 2nd touch sense mode operating to detect touch input of stylus pen;
the touch mode switching part making switching motion so that scan signal of the 1st frequency in the 1st touch sense mode be output to the 1st scan switching part and the scan signal of the 1st frequency, which is output through the 2nd scan switching part will be input to the 2nd impedance matching part and, in the 2nd touch detection sense mode, the scan signal of the 1st frequency be output to the 1st and 2nd scan switching parts in order;
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit.

22. The apparatus for the coordinate input device with advanced touch sensing of claim 21, wherein the switching motion in a way that the 1st frequency signal in the 2nd touch sense mode bypasses and does not pass through the 1st impedance interface and be output to the 1st scan switching part and 2nd scan switching part in order.

23. The apparatus for the coordinate input device with advanced touch sensing of claim 19, wherein the power transmission antenna is included for transmit power to stylus pen embedding resonant circuit and the multiple sensing strip antenna as has the 1st touch sense mode operating to detect touch input of capacitive object and the 2nd touch sense mode operating to detect touch input of stylus pen;
the touch mode switching part making switching motion so that, in the 1st touch sense mode, the scan signal of the 1st frequency be output to the 1st scan switching part and, the scan signal of the 1st frequency be output to the 2nd impedance matching part and, in the 2nd touch sense mode, the scan signal of the 1st frequency will be output to the power transmission antenna;
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit.

24. The apparatus for the coordinate input device with advanced touch sensing comprising:
a sensing panel which is placed in the latter part of display panel embedding multiple pixels that is driven to present video images; and
a multiple sensing strip antenna which is installed in sensing panel and includes the 1st sensing strip antenna group for detecting the 1st coordinate from touch input coordinate and the 2nd sensing strip antenna group for detecting the 2nd coordinate from touch input coordinate; and sensing control circuit which supply scan signals to multiple sensing strip antenna for detecting touch input coordinate of capacitive object, which touches the front of display panel , and calculates touch input coordinate based on the variation of electric property related to impedance matching of scan signals which are generated in responding to the touch input coordinate of capacitive object.

25. The apparatus for the coordinate input device with advanced touch sensing of claim 24, wherein the 1st scan switching parts for selectively driving the 1st sensing strip antenna group;
the 2nd scan switching parts for selectively driving the 2nd sensing strip antenna group;
the scan signal source supplying scan signals of the 1st and 2nd frequencies;
the 1st impedance matching part which is organized between scan signal source and the 1st scan switching parts;
the 2nd impedance matching part which is organized between scan signal source and the 2nd scan switching parts; capacitive touch detection part which performs electric signal processing for detecting variation of electric property related to impedance matching of scan signals of the 1st and 2nd frequencies which are respectively loaded in the 1st and 2nd sensing strip antenna groups at the same time; and
the controller which calculates touch input coordinate of stylus pen by receiving signals which have been processed through capacitive touch detection part and detecting variation of electric property related to impedance matching of scan signals of the 1st frequency according to existence /non- existence of touch of capacitive object.

26. The apparatus for the coordinate input device with advanced touch sensing of claim 25, wherein the voltage sensor and current sensor in order to detect electric property of scan signal of capacitive touch.

27. The apparatus for the coordinate input device with advanced touch sensing of claim 25, wherein the 1st touch sense mode running for detecting touch input of capacitive object and the 2nd touch sense mode running for detecting touch input of stylus pen embedding resonant circuit;
the touch mode switching part running switching motion so that: in the 1st touch detection mode, scan signal of the 1st frequency is out put into the 1st scan switching part and, at the same time, the scan signal of the 2nd frequency is output in the 2nd scan switching part; and, in the 2nd touch detection mode, the scan signal of the 1st frequency will be output to the 1st and 2nd scan switching parts in order; and
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency, are received

28. The apparatus for the coordinate input device with advanced touch sensing of claim 27, wherein the switching motion in a way that the 1st frequency signal in the 2nd touch sense mode bypasses and does not pass through the 1st impedance interface and be output to the 1st scan switching part and 2nd scan switching part in order

29. The apparatus for the coordinate input device with advanced touch sensing of claim 25, wherein the power transmission antenna is included for transmit power to stylus pen embedding resonant circuit;
the multiple sensing strip antenna as has the 1st touch sense mode operating to detect touch input of capacitive object and the 2nd touch sense mode operating to detect touch input of stylus pen;
the touch mode switching part making switching motion so that, in the 1st touch sense mode, the scan signal of the 1st frequency be output to the 1st scan switching unit and, at the same time, the scan signal of the 2nd frequency be output to the 2nd scan switching part and, in the 2nd touch sense mode, the scan signal of the 1st frequency will be output to the power transmission antenna;
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit

30. The apparatus for the coordinate input device with advanced touch sensing of claim 29, wherein the power transmission antenna is installed inner side of external cover, which is installed in the edge area of display panel and includes magnetic cover to be installed to cover such power transmission antenna.

31. The apparatus for the coordinate input device with advanced touch sensing of claim 24, wherein the 1st scan switching parts for selectively driving the 1st sensing strip antenna group;
the 2nd scan switching parts for selectively driving the 2nd sensing strip antenna group;
the scan signal source supplying scan signals of the 1st frequency; the 1st impedance matching part which is organized between scan signal source and the 1st scan switching parts;
the capacitive touch detection part which performs electric signal processing for detecting variation of electric property related to impedance matching of scan signals of the 1st frequency which are loaded in the 1st sensing strip antenna group;
the 2nd impedance matching part which is organized between the 2nd scan switching parts and capacitive detection part and; and
the controller which calculates touch input coordinate of stylus pen by receiving signals which have been processed through capacitive touch detection part and detecting variation of electric property related to impedance matching of scan signals of the 1st frequency according to existence /non- existence of touch of capacitive object.

32. The apparatus for the coordinate input device with advanced touch sensing of claim 31, wherein the voltage sensor and current sensor in order to detect electric property of scan signal of capacitive touch.

33. The apparatus for the coordinate input device with advanced touch sensing of claim 31, wherein the multiple sensing strip antenna as has the 1st touch sense mode operating to detect touch input of capacitive object and the 2nd touch sense mode operating to detect touch input of stylus pen;
the touch mode switching part making switching motion so that scan signal of the 1st frequency in the 1st touch sense mode be output to the 1st scan switching part and the scan signal of the 1st frequency, which is output through the 2nd scan switching part will be input to the 2nd impedance matching part and, in the 2nd touch detection sense mode, the scan signal of the 1st frequency be output to the 1st and 2nd scan switching parts in order;
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit.

34. The apparatus for the coordinate input device with advanced touch sensing of claim 33, wherein the switching motion in a way that the 1st frequency signal in the 2nd touch sense mode bypasses and does not pass through the 1st impedance interface and be output to the 1st scan switching part and 2nd scan switching part in order.

35. The apparatus for the coordinate input device with advanced touch sensing of claim 31, wherein the power transmission antenna is included for transmit power to stylus pen embedding resonant circuit;
the multiple sensing strip antenna as which has the 1st touch sense mode operating to detect touch input of capacitive object and the 2nd touch sense mode operating to detect touch input of stylus pen;
the touch mode switching part making switching motion so that, in the 1st touch sense mode, the scan signal of the 1st frequency be output to the 1st scan switching part and, the scan signal of the 1st frequency be output to the 2nd impedance matching part and, in the 2nd touch sense mode, the scan signal of the 1st frequency will be output to the power transmission antenna;
the pen touch detection part where electric signal processing is performed for detecting touch input coordinate of stylus pen by detecting electric signal from multiple sensing strip antenna in the 2nd touch sense mode; and
the controller calculates touch input coordinate of stylus pen by receiving signals which have been processed through pen touch detection part in the 2nd touch sense mode and detecting whether radio frequency signals, which is transmitted from resonating of scan signals of the 1st frequency in stylus pen resonant circuit.

36. The apparatus for the coordinate input device with advanced touch sensing of claim 35, wherein the structure that the power transmission antenna is installed inner side of external cover, which is installed in the edge area of display panel and includes magnetic cover to be installed to cover such power transmission antenna.

37. The apparatus for the coordinate input device with advanced touch sensing of claim 24, wherein the sensing panel is installed either in front or in the rear of optical sheet of backlight unit illuminating the light toward display panel from the rear of such display panel.

38. The apparatus for the coordinate input device with advanced touch sensing of claim 24, wherein the sensing panel is installed either in front or in the rear of optical sheet of backlight unit illuminating the light toward display panel from the rear of such display panel.

39. The apparatus for the coordinate input device with advanced touch sensing of claim 24, wherein the shield sheet is included in order to block magnetic interference between circuit board which is placed in the rear of sensing panel.

40. The apparatus for the coordinate input device with advanced touch sensing of claim 39, wherein the shield sheet has a single shield area or more than two separate shield areas.

41. The apparatus for the coordinate input device with advanced touch sensing of claim 39, wherein the shield sheet includes magnet layer and carbon fiber layer which are organized in a side of the substrate.

42. The apparatus for the coordinate input device with advanced touch sensing of claim 24, wherein the multiple sensing strip antenna is organized either by forming conductive film by printing processing, vapor deposition or etching process on the surface of sensing panel board or by attaching un- insulated conductive wires.

43. The apparatus for the coordinate input device with advanced touch sensing of claim 24, wherein the conductive bezel trace which is formed in bezel area of the sensing panel is to be organized either by forming conductive film by printing processing, vapor deposition or etching process on the surface of sensing panel board or by attaching uninsulated conductive wires.

44. The apparatus for the coordinate input device with advanced touch sensing of claim 43, wherein the magnetic cover to be installed in bezel area of dual sensing plates so as to cover such the bezel trace.
